# EUROPÄISCHE PATENTSCHRIFT

(11) **EP 1 684 002 B1**
(45) Veröffentlichungstag und Bekanntmachung des Hinweises auf die Patenterteilung: **03.11.2010**
(21) Anmeldenummer: 06000553.5
(22) Anmeldetag: 12.01.2006
(51) Int. Cl.: F21S 8/10, F21V 8/00, F21W 101/14, F21Y 101/02

(54) **Leuchteinheit mit Lichtteiler**
Lighting unit with light distributor
Unité d' éclairage avec distributeur de lumière

(30) Priorität: 24.01.2005 DE 102005003367
(43) Veröffentlichungstag der Anmeldung: 26.07.2006
(73) Patentinhaber: odelo GmbH, 71409 Schwaikheim (DE)
(72) Erfinder: Stefanov, Emil, Dr., 73730 Esslingen (DE)
(74) Vertreter: Kaufmann, Ursula Josefine

(56) Entgegenhaltungen:
- EP-A- 0 940 625
- WO-A-99/09349
- DE-A1- 10 022 420
- FR-A- 2 853 392
- US-A- 4 698 730

## Beschreibung

Die Erfindung betrifft eine Leuchteinheit mit mindestens einer Lichtquelle, mit mindestens einem der Lichtquelle optisch nachgeschalteten, Lichtreflexionsflächen aufweisenden Lichtteiler und mit mindestens einem den Lichtreflexionsflächen optisch nachgeschalteten Lichtumlenkbereich, wobei die Richtung des umgelenkten und den Lichtumlenkbereich verlassenden Lichts von der Lichtquelle weg zeigt.

Aus der EP 0 780 265 B1 ist eine derartige Leuchteinheit bekannt. Für den Betrachter erscheint der zentrale Bereich dunkel.

Die FR-A-2 853 392 offenbart eine Leuchteinheit mit mindestens einer Lichtquelle, mit mindestens einem der Lichtquelle optisch nachgeschalteten, Lichtreflexionsflächen aufweisenden Lichtteiler und mit mindestens einem den Lichtreflexionsflächen optisch nachgeschalteten Lichtumlenkbereich, wobei die Richtung des umgelenkten und den Lichtumlenkbereich verlassenden Lichts von der Lichtquelle weg zeigt, wobei dem Lichtteiler ein optisches Element optisch vorgeschaltet ist, das in der Lichtquelle erzeugtes Licht zumindest annähernd parallelisiert und wobei der Lichtteiler von der Lichtquelle durchleuchtete Lichtdurchtrittsflächen aufweist, die zumindest annähernd normal zur Richtung des parallelen Lichts liegen.

Die WO99/09349 A offenbart eine vergleichbare Leuchteinheit, die jedoch nur eine Lichtdurchtrittsfläche aufweist.

Die US-A-4 698 730 offenbart eine Lichtquelle, welche eine erhöhte Lichtausbeute ermöglicht, wobei das erzeugte Licht durch ein optisches Element, das der Lichtquelle nachgeschaltet ist, parallelisiert werden kann.

Der vorliegenden Erfindung liegt daher die Problemstellung zugrunde, eine kompakte Leuchteinheit zu entwickeln, die eine homogene Leuchtdichtenverteilung erzeugt.

Diese Problemstellung wird mit den Merkmalen des Hauptanspruches gelöst. Dem Lichtteiler ist ein optisches Element optisch vorgeschaltet, das in der Lichtquelle erzeugtes Licht zumindest annähernd parallelisiert. Außerdem weist der Lichtteiler von der Lichtquelle durchleuchtete Lichtdurchtrittsflächen auf, die zumindest annähernd normal zur Richtung des parallelen Lichts liegen.

Weitere Einzelheiten der Erfindung ergeben sich aus den Unteransprüchen und der nachfolgenden Beschreibung schematisch dargestellter Ausführungsformen.
- Figur 1:: Schnitt durch eine Leuchteinheit mit Lichtquelle und Lichtverteilern;
- Figur 2:: Dimetrische Ansicht eines Drahtmodells der Leuchteinheit nach Figur 1;
- Figur 3:: Lichtquelle einer Leuchteinheit nach Figur 1;
- Figur 4:: Detail eines Lichtteilers;
- Figur 5:: Detail eines Lichtteilers;
- Figur 6:: Detail eines Lichtumlenkbereichs;
- Figur 7:: Detail eines Lichtumlenkbereichs;
- Figur 8:: Detail optischer Umlenkstrukturen;
- Figur 9:: Seitenansicht einer Leuchteinheit mit einem Flächenlichtleiter;
- Figur 10:: Rückansicht einer Leuchteinheit nach Figur 9;
- Figur 11:: Drahtmodell einer Leuchteinheit mit Umlenkstrukturen nach Figur 8;
- Figur 12:: Anordnung mit drei Leuchteinheiten.

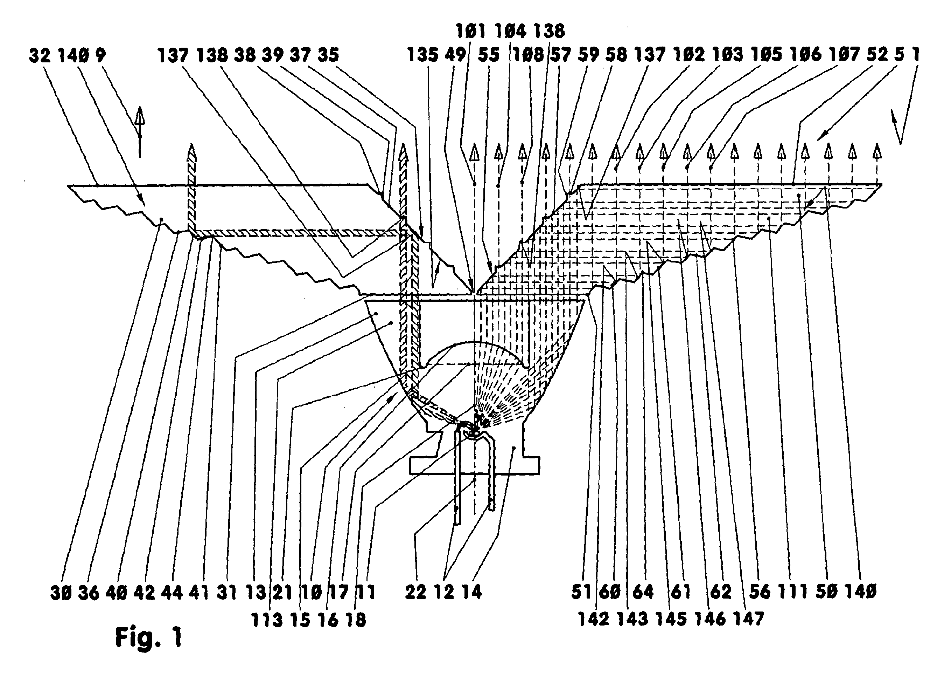

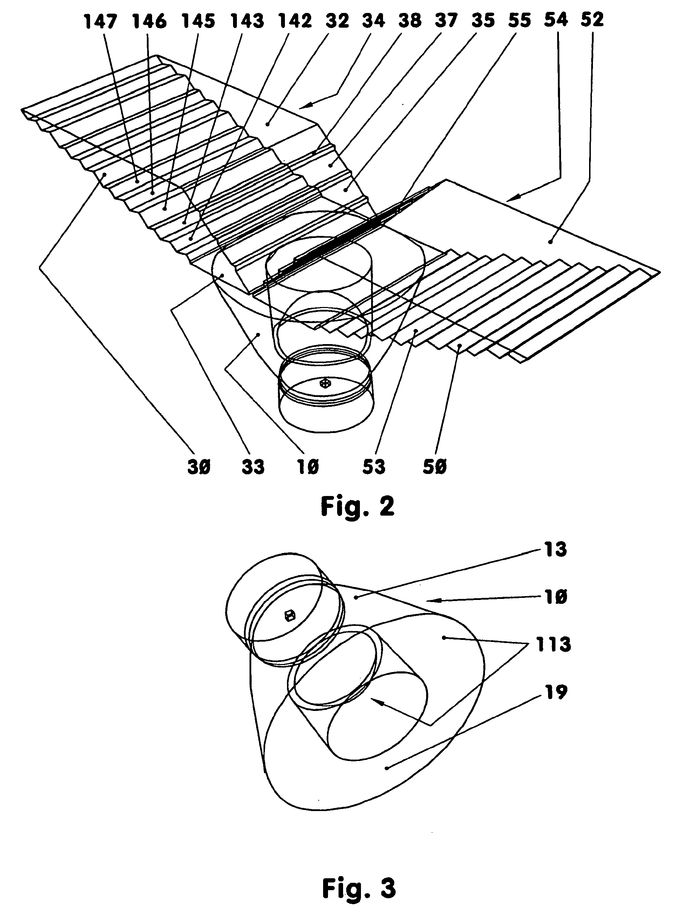

Die Figur 1 zeigt einen Schnitt durch eine Leuchteinheit (5) mit einer Lichtquelle (10) und mit zwei Lichtverteilern (30, 50). Diese Leuchteinheit (5) ist beispielsweise ein Teil einer in dieser Figur nicht weiter dargestellten Heckleuchte eines Kraftfahrzeuges. In der Figur 2 ist ein Drahtmodell dieser Leuchteinheit (5) in einer dimetrischen Ansicht und in der Figur 3 eine dimetrische Ansicht der Lichtquelle (10) dieser Leuchteinheit (5) dargestellt.

Die Lichtquelle (10) ist z.B. eine Leucht- oder Lumineszenzdiode (10). Sie umfasst einen lichtemittierenden Chip (11) mit elektrischen Anschlüssen (12) und einen Lichtumlenkkörper (13).

Der Lichtumlenkkörper (13) ist ein z.B. transparenter, lichtbrechender Körper. Der Werkstoff des Lichtumlenkkörpers (13) ist beispielsweise ein thermoplastischer Kunststoff, z.B. PMMA, PMMI, etc., oder Glas. Der Lichtumlenkkörper (13) besteht z.B. aus einem Sockel (14) und aus einem Paraboloidstumpf (15), in dessen Brennpunkt beispielsweise der lichtemittierende Chip (11) liegt. Der Paraboloidstumpf (15) hat eine plane, ringförmige Lichtaustrittsfläche (19), die normal zur optischen Achse (22) der Lichtquelle (10) liegt. Die ringförmige Lichtaustrittsfläche (19) umgibt eine in den Paraboloidstumpf (15) eingesenkte zweite Lichtaustrittsfläche (16). Diese ist z.B. eine optische Linse (16), beispielsweise eine Sammellinse, sie kann z.B. als Fresnellinse ausgeführt sein. Um die optische Linse (16) herum liegt beispielsweise eine Hohlkehle (21). Der Abstand der gedachten Grundfläche (17) der optischen Linse (16) zum lichtemittierenden Chip (11) ist größer als die Brennweite der optischen Linse (16). Dieser Abstand entspricht etwa der Hälfte der Länge des Lichtumlenkkörpers (13) zwischen dem lichtemittierenden Chip (11) und der Lichtaustrittsfläche (19) der Leuchtdiode (10). Der äußere Durchmesser der Lichtaustrittsfläche (19), er beträgt beispielsweise 9 mm, ist in diesem Ausführungsbeispiel doppelt so groß wie der äußere Durchmesser der Hohlkehle (21).

Die beiden Lichtverteiler (30, 50) sind beispielsweise achsensymmetrisch zur optischen Achse (22) der Lichtquelle (10) angeordnete Körper, deren in der Figur 1 dargestellte Querschnittsfläche jeweils zumindest annähernd die Form eines Trapezes hat. Die beiden Lichtverteiler (30, 50) haben jeweils eine Lichteintrittsfläche (31, 51) und eine Lichtaustrittsfläche (32, 52). Diese Flächen (31, 32, 51, 52) sind hier parallel zueinander. Sie sind außerdem parallel zur Lichtaustrittsfläche (19) der Lichtquelle (10). Die Lichtaustrittsflächen (32, 52) sind jeweils um etwa 25% der Länge des einzelnen Lichtverteilers (30, 50) gegenüber der Lichteintrittsflächen (31, 51) von der optischen Achse (22) nach außen hin versetzt. Die Länge der Lichteintrittsfläche (31, 51) des einzelnen Lichtverteilers (30, 50), in der Darstellung der Figur 1 in Querrichtung zur optischen Achse (22), beträgt im Ausführungsbeispiel etwa 28% und die Länge der Lichtaustrittsfläche (32, 52) etwa 75% der Länge dieses Lichtverteilers (30, 50). Im diesem Ausführungsbeispiel beträgt die Summe der Längen beider Lichtverteiler (30, 50) beispielsweise 35 mm. Die Höhe des Lichtverteilers (30, 50) beträgt in der Darstellung der Figuren 1 und 2 z.B. 26% der Länge dieses Körpers (30, 50). Die beiden Seitenflächen (33, 34; 53, 54) eines jeden Lichtverteilers (30, 50) sind zueinander parallel.

Die entgegengesetzt zueinander liegenden, nichtparallelen und in der Schnittdarstellung der Figur 1 unterschiedlich langen Stirnseitenflächen (35, 36; 55, 56) der Lichtverteiler (30, 50) sind aus einzelnen Flächenelementen (37 - 39, 40 - 42; 57 - 59, 60 - 62) zusammengesetzt. Die jeweilige kurze Stirnseitenfläche (35; 55) besteht beispielsweise aus fünf schrägliegenden Flächenelementen (37; 57) und aus zwischen diesen Flächenelementen (37; 57) angeordneten weiteren vier Flächenelementen (38; 58) sowie aus Freiflächenelementen (39; 59), die an die Flächenelemente (38; 58) angrenzen.

Die Flächenelemente (37; 57) und die Lichteintrittsfläche (31) schließen beispielsweise einen Keilwinkel von 45 Grad ein. Die einzelnen Flächenelemente (37; 57) sind gleich groß und liegen in einer gemeinsamen Ebene.

Die Flächenelemente (38; 58) grenzen beispielsweise an das in der Figur 1 jeweils oberhalb liegende Flächenelement (37; 57) an. Diese Flächenelemente (38; 58) liegen parallel zur Lichteintrittsfläche (31; 51). Die einzelnen Flächenelemente (38; 58) sind beispielsweise gleich lang, ihre Länge beträgt z.B. 1,4% der Länge des Lichtverteilers (30; 50). In einer gedachten Projektion auf die Lichteintrittsflächen (31, 51) haben jeweils zwei benachbarte Flächenelemente (38; 58) zueinander einen Abstand von beispielsweise 5,8% der Länge eines Lichtverteilers (30; 50).

Die Flächenelemente (38; 58) ragen in der Darstellung der Figur 1 aus den Stirnseitenflächen (35; 55) heraus. Je ein Freiflächenelement (39; 59), das z.B. normal zu den Flächenelementen (38; 58) liegt, verbindet ein Flächenelement (38; 58) mit einem unterhalb liegenden schrägliegenden Flächenelement (37; 57).

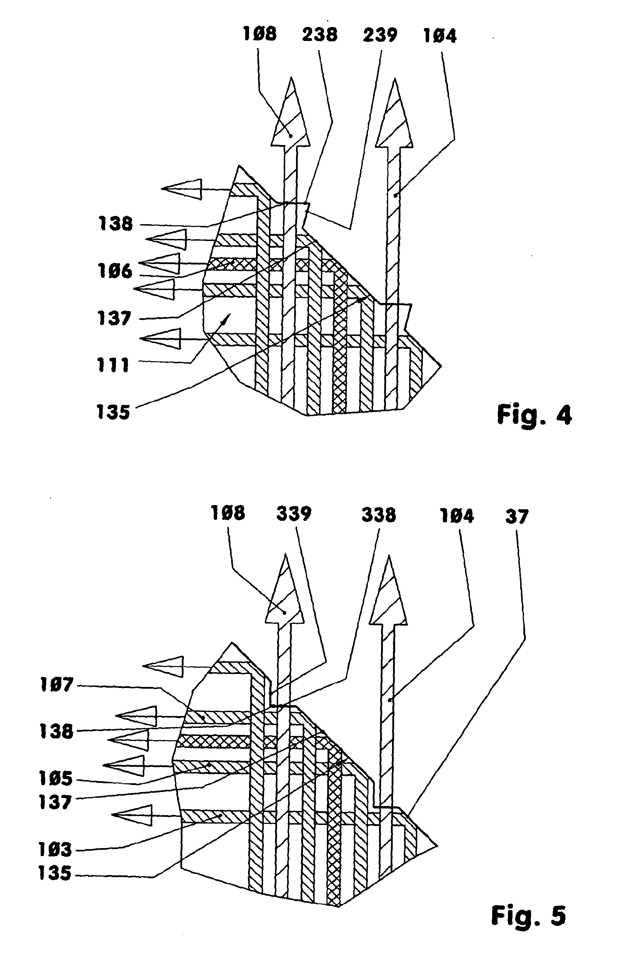

In den Figuren 4 und 5 sind beispielsweise zwei weitere Ausführungsvarianten der Stirnseitenfläche (35) eines Lichtverteilers (30) gezeigt. In der Figur 4 sind die Flächenelemente (238) z.B. um 10% länger als die in der Figur 1 dargestellten Flächenelemente (38). Die Freiflächenelemente (239) und die Flächenelemente (238) begrenzen einen spitzwinkligen Keil.

Die Figur 5 zeigt Flächenelemente (338), die in den Lichtverteiler (30) eingeprägt sind. Auch diese Flächenelemente (338) liegen beispielsweise parallel zur hier nicht dargestellten Lichteintrittsfläche des Lichtverteilers (30). Hierbei verbinden die Freiflächenelemente (339) jeweils ein Flächenelement (338) mit einem in der Darstellung der Figur 5 oberhalb angeordneten schrägliegenden Flächenelement (37).

Die langen Stirnseitenflächen (36, 56) der Lichtverteiler (30, 50) bestehen jeweils beispielsweise aus 25 angeordneten Flächenelementen (40 - 42; 60 - 62), vgl. die Figuren 1 und 2. Eine Hälfte (40, 41; 60, 61) dieser Flächenelemente (40 - 42; 60 - 62) liegt z.B. gestaffelt angeordnet parallel zu den schrägliegenden Flächenelementen (37; 57) der kurzen Stirnseitenflächen (35; 55). Diese Flächenelemente (40, 41; 60, 61) werden im folgenden als Stufenflächenelemente (40, 41; 60, 61) bezeichnet. Die anderen, ebenfalls gestaffelt angeordneten Flächenelemente (42; 62) sind Freiflächenelemente und verbinden die Flächenelemente (40, 41; 60, 61) miteinander. Die Freiflächenelemente (42; 62) schließen mit jeweils einem in einer Scheitelstrecke (44; 64) angrenzenden Stufenflächenelement (40, 41; 60, 61) einen Winkel ein, der beispielsweise kleiner ist als 135 Grad.

Bei einer gedachten Projektion auf die Ebene der Lichteintrittsflächen (31, 51) haben in der Darstellung der Figur 1 je zwei benachbarte Scheitelstrecken (44; 64) zueinander beispielsweise den gleichen Abstand.

Die Stufenflächenelemente (40, 41; 60, 61) haben in den in den in den Figuren 1 und 2 dargestellten Lichtverteilern (30, 50) zwei unterschiedliche Größen. So sind in der Figur 1 beispielsweise - von der Lichteintrittsfläche (31; 51) gezählt - die vierte, die siebte die zehnte und die dreizehnte Stufenfläche (41; 61) um 50% größer als die übrigen Stufenflächen (40; 60). Jede zur Lichteintrittsfläche (31; 51) parallele gedachte Gerade in Längsrichtung des Lichtverteilers (30; 50) durch ein Freiflächenelement (39; 59) der kurzen Stirnseitenfläche (35) schneidet im Ausführungsbeispiel der Figur 1 ein großes Stufenflächenelement (41; 61) der langen Stirnseitenfläche (36).

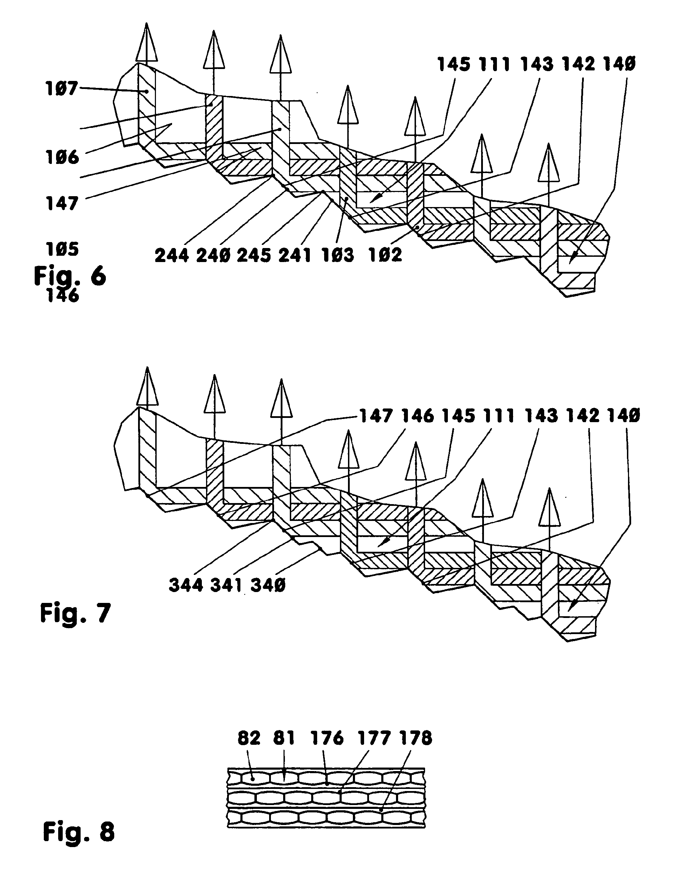

In den Figuren 6 und 7 sind weitere Ausführungsformen einer langen Stirnseitenfläche (36) dargestellt. Die Anzahl und die Winkellage der Stufenflächenelemente (240, 241; 340, 341) ist beispielsweise identisch der in den Figuren 1 und 2 gezeigten Ausführungsform. In der Figur 6 ist der Abstand der auf die Ebene der Lichteintrittsfläche (31) projizierten Scheitelstrecken (244, 245) nicht konstant. Die Scheitelstrecken (244) begrenzen die kleinen Stufenflächenelementen (240), die Scheitelstrecken (245) liegen an den großen Stufenflächenelementen (241). In diesem Ausführungsbeispiel sind die großen Stufenflächenelemente (241) um 87% größer als die kleinen Stufenflächenelemente (240).

Auch der in der Figur 7 dargestellte Lichtverteiler (30) hat Stufenflächen (340, 341) unterschiedlicher Größe. Hierbei sind die großen Stufenflächenelemente (341) beispielsweise 80% größer als die kleinen Stufenflächenelemente (340). Alle Scheitelstrecken (344), die ein großes Stufenflächenelement (341) begrenzen, haben in einer Projektion auf die Ebene der Lichteintrittsseite (31) beispielsweise zu beiden benachbarten, je ein großes Stufenflächenelement (341) begrenzenden Scheitelstrecken (344) denselben Abstand.

Der einzelne Lichtverteiler (30; 50) kann Kombinationen der beschriebenen Ausführungsformen aufweisen. So kann er beispielsweise eine kurze Stirnseitenfläche (35; 55) nach Figur 4 und eine lange Stirnseitenfläche (36; 56) nach Figur 7 haben.

Auch können die Stirnseitenflächen (35, 36; 55, 56) abschnittsweise unterschiedliche Gestaltungen haben.

Der Abstand der beiden Lichtverteiler (30; 50) zueinander, die Länge des Spalts (49), entspricht der Länge eines der in Figur 1 dargestellten Flächenelemente (38; 58). Die beiden Lichtverteiler (30; 50) können auch miteinander verbunden sein, z.B. mittels eines zentralen Stegs konstanter Stärke. Statt zweier Lichtverteiler (30; 50) kann beispielsweise auch ein einzelner rotationssymmetrischer Lichtverteiler eingesetzt werden. Die Rotationsachse ist in diesem Fall beispielsweise die optische Achse (22) der Lichtquelle (10).

Beim Betrieb der Leuchteinheit (5) wird in der Lichtquelle (10) Licht (101 - 108) vom lichtemittierenden Chip (11) erzeugt. Ein Teil des in der Figur 1 gestrichelt dargestellten, vom lichtemittierenden Chip (11) emittierten Lichts (101 - 108) trifft auf die Grenzfläche des Lichtumlenkkörpers (13), der durch die Sammellinse (16) gebildet wird. Der Winkel, der durch das auftreffende Licht und eine Normale im Auftreffpunkt eingeschlossen wird, ist kleiner als der Grenzwinkel der Totalreflexion. Dieser Grenzwinkel beträgt bei PMMA beispielsweise 42 Grad. Das auftreffende Licht tritt durch die Sammellinse hindurch, wobei es in Richtung der optischen Achse (22) gebrochen wird. Das aus der Sammellinse (16) austretende Licht liegt parallel zur optischen Achse (22) der Leuchteinheit (5).

Der Teil des vom lichtemittierenden Chip (11) emittierten Lichts (101 - 108), der nicht durch die Sammellinse (16) hindurchtritt, trifft auf die Grenzfläche des Lichtumlenkkörpers (13), die durch die Mantelfläche des Paraboloidstumpfes (15) gebildet wird. Der Auftreffwinkel ist größer als der Grenzwinkel der Totalreflexion. Dieser Teil des Lichtbündels (101 - 108) wird vollständig in Richtung der Lichtaustrittsfläche (19) reflektiert. Es durchtritt die Lichtaustrittsfläche (19) in normaler Richtung und liegt ebenfalls parallel zur optischen Achse (22) der Lichtquelle (10). Der Lichtumlenkkörper (13) der Lichtquelle (10) parallelisiert bzw. kollimiert das vom lichtemittierenden Chip (11) emittierte Licht (101 - 108). Er wirkt somit für das Licht (101 - 108) als Kollimator (113). Die Richtung (9) des von der Lichtquelle (10) emittierten parallelisierten Lichts (101 - 108) ist beispielsweise parallel zur optischen Achse (22) der Lichtquelle (10).

Das parallelisierte Licht (101 - 108) tritt durch die Lichteintrittsflächen (31, 51) in die Lichtverteiler (30, 50). In den Lichtverteilern (30, 50) trifft es auf die Grenzflächen, die durch die kurzen Stirnseiten (35, 55) gebildet werden. Diese beiden Grenzflächen bilden für das Lichtbündel (101 - 108) einen Lichtteiler (135).

Das Lichtbündel (101 - 108) trifft auf den Lichtteiler (135) sowohl in den Abschnitten auf, in denen die in der Figur 1 waagerecht dargestellten Flächenelemente (38, 58) den jeweiligen Lichtverteiler (30, 50) begrenzen, als auch auf den Spalt (49) zwischen den Lichtverteilern (30, 50) und in den Abschnitten, in denen die in dieser Figur schräg liegenden Flächenelemente (37, 57) die Körperbegrenzung bilden. Das in den waagerecht dargestellten Abschnitten (38, 58) normal auf die Grenzfläche auftreffende Licht (104, 108) tritt durch diese Grenzflächen hindurch in die Umgebung (1). Die von der Lichtquelle (10) ausgeleuchteten Bereiche dieser Grenzflächen sind Lichtdurchtrittsflächen (138). Diese Lichtdurchtrittsflächen (138) liegen zumindest annähernd normal zur Richtung (9) des parallelen Lichts (101 - 108). Auch der Spalt (49) bildet eine Lichtdurchtrittsfläche (138), durch den ein Lichtbündel (101) in die Umgebung (1) austritt. Alle Lichtdurchtrittsflächen (138) haben in einer Projektion entgegen der Richtung des parallelisierten Lichts (101 - 108) die gleiche Größe und zu jeweils zwei benachbarten Lichtdurchtrittsflächen (138) den gleichen Abstand.

Lichtbündel (102, 103, 105 - 107), die auf die durch die schräg dargestellten Flächenelemente (37, 57) gebildeten Grenzflächen auftreffen, treffen hier unter einem Winkel zur Normalen auf die Grenzfläche auf, der größer ist als der Grenzwinkel der Totalreflexion des Werkstoffs des jeweiligen Lichtverteilers (30, 50) gegen Umgebungsluft (1). Diese Grenzflächen bilden Lichtreflexionsflächen (137), an denen das auftreffende Licht (102, 103, 105 - 107) beispielsweise vollständig in Längsrichtung des jeweiligen Lichtteilers (30, 50) umgelenkt wird. Nach der Reflexion liegen die Lichtbündel (102, 103, 105 - 107) wieder parallel zueinander. Zwischen den Lichtbündeln (102, 103, 105 - 107) liegen nicht ausgeleuchtete Lücken (111), da das durch die Lichtdurchtrittsflächen (138) durchtretende Licht (101, 104, 108) nicht umgelenkt wird. Die durch die Freiflächenelemente (39) gebildeten Grenzflächen der Lichtverteiler (30, 50) werden nicht ausgeleuchtet.

Ist der Lichtverteiler (30; 50) wie in den Figuren 4 oder 5 gestaltet, wird das von der Lichtquelle (10) emittierte Licht (101 - 108) an dem in diesen Figuren gezeigten Lichtteilerabschnitt (135) zumindest ähnlich aufgeteilt wie bei dem in der Figur 1 dargestellten Lichtteiler (135). In den Figuren 4 und 5 ist beispielsweise von den parallelisierten, einander tangierenden Lichtbündeln (103 - 108) zur Veranschaulichung jeweils nur der zentrale Bereich dargestellt. Bei einer Ausführung nach Figur 4 wird das durch die Lichtdurchtrittsflächen (138) durchtretende Licht (104, 108) aufgrund der rückspringenden Freiflächen (239) z.B. nicht reflektiert oder gebrochen. Die Lichtdurchtrittsflächen (138) sind in dem Ausführungsbeispiel nach Figur 4 nur die Bereiche der durch die Flächenelemente (238) gebildeten Grenzflächen, die von der Lichtquelle (10) ausgeleuchtet werden.

Die am Lichtteiler (135) umgelenkten Lichtbündel (102, 103, 105 - 107) treffen auf die gestaffelt angeordneten Grenzflächen des jeweiligen Lichtverteilers (30; 50), die durch die Stufenflächenelemente (40, 41) gebildet werden, vgl. Figur 1. Hierbei werden diese Grenzflächen nur teilweise ausgeleuchtet. Die ausgeleuchteten Bereiche sind Lichtumlenkflächen (142, 143, 145 - 147) eines Lichtumlenkbereichs (140), an denen die Lichtbündel (102, 103, 105 - 107) in der Richtung der Lichtaustrittsfläche (32; 52) reflektiert werden. Das Lichtbündel (102) trifft hierbei beispielsweise auf die Lichtumlenkfläche (142) auf, das Lichtbündel (103) auf die Lichtumlenkfläche (143) und das Lichtbündel (105) auf eine Lichtumlenkfläche (145). Letztere ist z.B. Teil einer durch ein großes Stufenflächenelement (41; 61) gebildeten Grenzfläche. Das Lichtbündel (103), das z.B. in der Darstellung der Figur 1 oberhalb des Lichtbündels (102) liegt, tangiert die Lichtumlenkfläche (142) und trifft auf die nächst weiter vom Lichtteiler (135) entfernt liegende Lichtumlenkfläche (143). In einer Projektion entgegen der Richtung der an den Lichtumlenkflächen (142, 143, 145 - 147) umgelenkten Lichtanteile (102, 103, 105 - 107) ist der Abstand der Lichtumlenkflächen (142, 143, 145 - 147) zueinander gleich. Dieser Abstand entspricht in dieser Projektion auch dem Abstand der Lichtdurchtrittsflächen (138) zueinander und zu den Lichtumlenkflächen (142, 143, 145 - 147). Die Flächen (138, 142, 143, 145 - 147) haben in der Projektion beispielsweise die gleiche Größe. Die durch die Freiflächenelemente (42; 62) gebildeten Grenzflächen beeinflussen das Licht (102, 103, 105 - 107) nicht, es erfolgt beispielsweise keine Reflexion oder Brechung der Lichtbündel (102, 103, 105 -107). Die den Lichtteiler (135) durchtretenden und die im Umlenkbereich (140) umgelenkten Lichtbündel (101 - 108), die an der Lichtaustrittsseite (32; 52) austreten, haben zueinander den gleichen Abstand und den gleichen Querschnitt. Sie haben in diesem Ausführungsbeispiel die gleiche Richtung (9) wie das von der Lichtquelle (10) emittierte Licht (101 - 108). Die Lücken (111) treten nicht auf und sind für den Betrachter nicht sichtbar. Das aus der in den Figuren 1 und 2 austretende Licht (101 - 108) wird flächenmäßig anteilsmäßig gleich aufgeteilt. Beim Beobachten aus einer geeigneten Entfernung erzeugt es den Eindruck einer gleichmäßig verteilten Leuchtdichte.

Bei einer Ausführung der Lichtverteiler (30; 50) nach einer der Figuren 6 oder 7 wird im Lichtumlenkbereich (140) ebenfalls die Lücke (111) überbrückt, so dass sich eine gleichmä-βige Leuchtdichtenverteilung ergibt. Bei einer Ausführung nach Figur 6 wird z.B. die Lichtumlenkfläche (143) durch ein großes Stufenflächenelement (241) gebildet, während die Lichtumlenkflächen (142, 145 - 147) durch kleine Stufenflächenelemente (240) gebildet werden.

In der Figur 7 sind alle Lichtumlenkflächen (142, 143, 145 - 147) Teile von Grenzflächen, die durch große Stufenflächenelemente (341) gebildet werden.

Die Größe der Lichtumlenkflächen (142, 143, 145 - 147) kann beispielsweise mit zunehmendem Abstand vom Lichtteiler (135) zunehmen. Die entgegen der Richtung des aus den Lichtaustrittsflächen (32; 52) austretenden Lichts (101 - 108) projizierten Mittellinien der Lichtumlenkflächen (142, 143, 145 - 147) haben dann beispielsweise den gleichen Abstand zueinander. Bei großen Lichtverteilern (30; 50) kann so z.B. die Schwächung der Lichtstärke durch die Werkstoffabsorption kompensiert werden.

Die so projizierten Lichtumlenkflächen (142, 143, 145 - 147) und Lichtdurchtrittsflächen (138) können auch unterschiedlich groß sein. So können beispielsweise bei einer Leuchtdiode (10) Bereiche unterschiedlicher Lichtstärke ausgeglichen werden. Beispielsweise können Bereiche großer Lichtstärke kleine Lichtumlenkflächen (142, 143, 145 - 147) und Lichtdurchtrittsflächen (138) ausleuchten, während Bereiche kleiner Lichtstärke große Flächen (138, 142, 143, 145 - 147) beleuchten.

Der Lichtteiler (135) und die Lichtumlenkflächen (142, 143, 145 - 147) können Teile unterschiedlicher Körper sein. Beispielsweise können die Lichtreflexionsflächen (137) des Lichtteilers (135) um die Lichtumlenkflächen (142, 143, 145 - 147) Spiegelflächen einzelner, ggf. einstellbarer Spiegel sein.

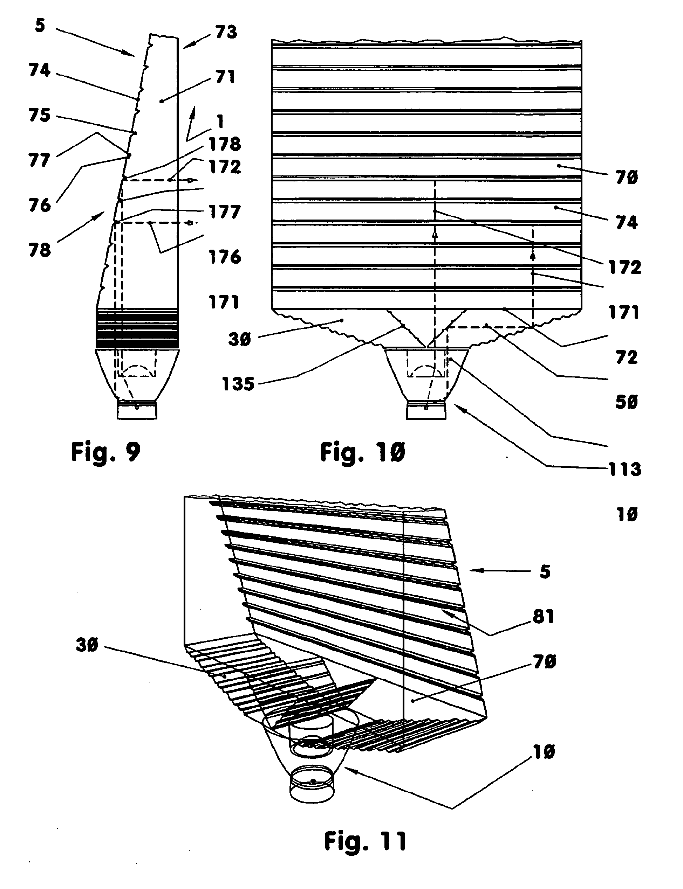

Die Figuren 9 und 10 zeigen eine Vorderansicht und eine Seitenansicht einer Leuchteinheit (5) mit einem Flächenlichtleiter (70). Als Lichtquelle (10) und als Lichtverteiler (30, 50) sind beispielsweise die in den Figuren 1 und 2 beschriebenen Bauelemente eingesetzt.

Der in diesen Figuren 9 und 10 dargestellte Flächenlichtleiter (70) hat die Gestalt eines regulären dreiseitigen Prismas, dessen Grund- (71) und Deckfläche parallele und kongruente rechtwinklige Dreiecke sind. Er ist beispielsweise ein transparenter Kunststoffkörper, z.B. aus dem gleichen Werkstoff wie der Lichtumlenkkörper (13) und/oder der Lichtverteiler (30, 50) .

Die Unterseite (72) des Flächenlichtleiters (70) ist z.B. eine rechteckige Planfläche, die beispielsweise unmittelbar auf den Lichtaustrittsflächen (32, 52) der Lichtverteiler (30, 50) aufliegt und diese abdeckt.

Senkrecht zu dieser Fläche (72) steht die z.B. als Planfläche ausgeführte Vorderseite (73) des Flächenlichtleiters (70). Die Höhe der Vorderseite (73) des hier gekürzt dargestellten Flächenlichtleiters (70) ist z.B. 80% größer als ihre Länge parallel zu den Lichtverteilern (30, 50). Die Vorderseite (73), die die Lichtaustrittsfläche (73) des Flächenlichtleiters (70) ist, ist in diesem Ausführungsbeispiel fünfundzwanzig mal so groß wie die Summe der Lichtaustrittsflächen (16, 19) der Lichtquelle (10). Die Lichtaustrittsfläche (73) kann auch mehr als zweihundertmal so groß sein wie die Summe der Lichtaustrittsflächen (16, 19)

Die Rückseitenfläche (74) des Flächenlichtleiters (70) hat z.B. waagerecht liegende dreieckige Kerben (75). Die Länge der einzelnen Kerben (75) ist gleich der Länge des Flächenlichtleiters (70). Diese Kerben (75) sind gestaffelt mit konstantem Abstand zueinander angeordnet. Der Abstand zwischen den einzelnen Kerben (75) ist beispielsweise doppelt so groß wie die Breite der einzelnen Kerbe (75), die z.B. 0,5 mm bis 1 mm beträgt. Die beiden Kerbflächen (76, 77) sind in der Darstellung der Figuren 9 und 10 Planflächen. Eine Normale auf die untere Kerbfläche (76) schließt mit einer gedachten Geraden, die normal zur Unterseite (72) liegt, z.B. einen Winkel ein, der grö-βer oder gleich dem Grenzwinkel der Totalreflexion für den Werkstoff des Flächenlichtleiters (70) gegen Luft (1) ist.

Auf der Rückseite (78) des Flächenlichtleiters (70) kann eine weitere, hier nicht dargestellte Lichtquelle angeordnet sein. Die Richtung des von dieser Lichtquelle emittierten Lichts ist dann beispielsweise zumindest annähernd normal zur Lichtaustrittsfläche (73) des Flächenlichtleiters (70).

Beim Betrieb der Leuchteinheit (5) wird das von der Lichtquelle (10) emittierte Licht (101 - 108) beispielsweise in den Lichtverteilern (30, 50) so aufgeteilt, wie im Zusammenhang mit den Figuren 1 - 7 beschrieben. In den einzelnen, parallel zueinander liegenden Lichtbündeln (101 - 108) ist der Lichtstrom weitgehend gleich.

Die Lichtbündel (101 - 108) treten durch die Unterseite (72) in den Flächenlichtleiter (70) ein. Im Flächenlichtleiter (70) treffen sie auf die Grenzflächen, die durch die Kerbflächen (76) gebildet werden. In den Figuren 9 und 10 sind beispielsweise zwei mögliche Lichtpfade (171, 172) dargestellt. Diese Lichtpfade (171, 172), die jeweils Teillichtbündel der Lichtbündel (101 - 108) sind, leuchten jeweils einen Teil der durch die Kerbflächen (76) gebildeten Grenzflächen aus. Die ausgeleuchteten Flächen sind Lichtreflexionsflächen (176 - 178). Der Teil des Lichtstroms (101 - 108), der beispielsweise die Lichtreflexionsfläche (176) tangiert, also in der Darstellung der Figur 9 rechts an der Lichtreflexionsfläche (176) vorbeigeht, trifft auf die nächst weiter entfernte Lichtreflexionsfläche (177).

Die auf diese Lichtreflexionsflächen (176 - 178) auftreffenden Teillichtströme (171 - 172) werden beispielsweise vollständig in Richtung der Vorderseite (73) umgelenkt und treten durch diese Lichtaustrittsfläche (73) hindurch in die Umgebung (1).

Der Betrachter sieht aus einem Abstand von etwa zwei bis drei Metern die homogen leuchtende Vorderseite (73) des Flächenlichtleiters (70) mit einer gleichmäßigen Leuchtdichtenverteilung.

Wird zusätzlich die auf der Rückseite (78) des Flächenlichtleiters (70) angeordnete Lichtquelle eingeschaltet, durchdringt das von dieser Lichtquelle emittierte Licht den Flächenlichtleiter (70) weitgehend ungehindert. Der Betrachter kann diese zusätzliche Lichtquelle klar erkennen. Je nach Leuchtdichte der Lichtquelle (10) und der zusätzlichen Lichtquelle wird bei gleichzeitigem Betrieb beider Lichtquellen entweder die Gesamtleuchtdichte erhöht oder nur eine Lichtquelle wahrgenommen.

Auf der Rückseite (78) des Flächenlichtleiters (70) können auch mehrere Lichtquellen angeordnet sein.

Der Flächenlichtleiter (70) kann gewölbt sein. So kann die Vorderseite (73) des Flächenlichtleiters (70) beispielsweise die Außenkontur eines Fahrzeuges bilden. Auch die Lichtverteiler (30, 50) einer derartigen Leuchteinheit (5) können eine z.B. an eine Fahrzeugaußenkontur angepasste gewölbte Gestalt aufweisen.

Die Figur 11 zeigt eine Leuchteinheit (5) mit einem Flächenlichtleiter (70), dessen Reflexionsflächen (176 - 178) optische Strukturen (81) aufweisen. Diese optischen Strukturen (81) sind beispielsweise eine Vielzahl zur Umgebung (1) hin gewölbter Ellipsoidenausschnitte (82).

Die Figur 8 zeigt einen Ausschnitt dieser optischen Strukturen (81), z.B. betrachtet von der Unterseite (72) eines transparenten Flächenlichtleiters (70) aus. Die Längsachse der einzelnen gedachten Ellipsoide liegt hierbei beispielsweise parallel zur Unterseite (72) und parallel zur Vorderseite (73) des Flächenlichtleiters (70). Hierbei sind die für die auftreffenden Lichtbündel (101 - 108) hintereinander angeordneten Reflexionsflächen (176 - 178) übereinander dargestellt. Die auf den einzelnen Reflexionsflächen (176 - 178) angeordneten Ellipsoidenausschnitte (82) sind beispielsweise versetzt zueinander angeordnet.

Die auf die Reflexionsflächen (176 - 178) auftreffenden Lichtbündel (101 - 108) werden an den optischen Strukturen (81) reflektiert. Das reflektierte Licht wird im Raum so verteilt, dass beispielsweise ein Raumwinkelbereich von +/- 20 Winkelgraden in horizontaler Richtung und +/- 10 Winkelgraden in vertikaler Richtung ausgeleuchtet wird.

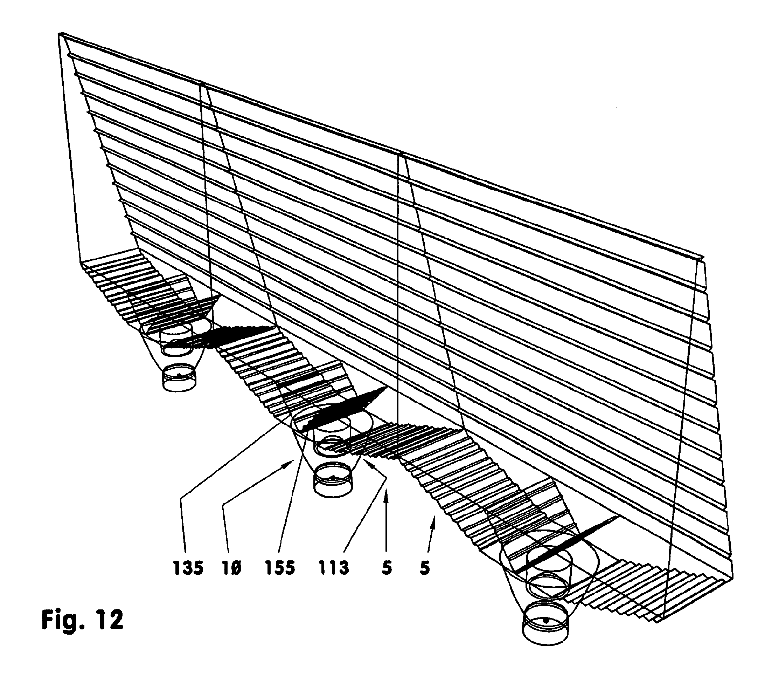

In der Figur 12 ist eine Anordnung von drei Leuchteinheiten (5) dargestellt. Diese sind nebeneinander angeordnet, wobei z.B. die Stirnflächen der Flächenlichtleiter (70) aneinander angrenzen. Hiermit kann beispielsweise eine großflächige Leuchte erzeugt werden. Selbstverständlich kann bei dieser Anordnung eine Lichtquelle oder es können mehrere Lichtquellen an der Rückseite (78) des Flächenlichtleiters (70) angeordnet sein.

Die in den Figuren 1, 2, 9 - 12 dargestellten Leuchteinheiten (5) können einteilig ausgeführt sein. So kann die gesamte Leuchteinheit (5) ein Spritzgussteil bilden, in das die Lichtquelle (10) eingeformt ist oder an das die Lichtquelle (10) angeformt ist. Die Lichtquelle (10), sie kann außer einer Leuchtdiode eine Glühlampe, Halogenlampe, etc. sein, kann auch an den oder an die Lichtverteiler (30, 50) angeclipst sein oder auf sonstige Weise mit diesen verbunden sein.

Das optische Element (113), das das von der Lichtquelle (10) emittierte Licht (101 - 108) parallelisiert, kann auch Teil eines Lichtverteilers oder der Lichtverteiler (30, 50) sein. Das auf den Lichtverteiler (135) auftreffende Licht (101 - 108) kann beispielsweise auch mittels einer optische Linse, einem z.B. parabolischen Reflektors etc. parallelisiert bzw. kollimiert werden.

Bei ausgeschalteter Lichtquelle (10) erscheint die Leuchteinheit (5) klar und unstrukturiert. Wird die Lichtquelle (10) eingeschaltet, erscheint aus der Position des Beobachters eine gleichmäßig leuchtende Fläche ohne Störungen.

Die Leuchteinheit (5) ist kompakt aufgebaut und kann so z.B. als Teil einer kombinierten Heckleuchte in einem Kraftfahrzeug eingesetzt werden. Beispielsweise kann diese ein Schlusslicht mit dahinter angeordneter Bremsleuchte und/oder Blinker umfassen.

Bezugszeichenliste:
- 1: Umgebung, Luft

- 5: Leuchteinheit

- 9: Richtung des emittierten parallelisierten Lichts

- 10: Lichtquelle, Leuchtdiode
- 11: lichtemittierenden Chip
- 12: elektrische Anschlüsse
- 13: Lichtumlenkkörper
- 14: Sockel
- 15: Paraboloidstumpf
- 16: optische Linse, Lichtaustrittsfläche von (10), Sammellinse
- 17: Grundfläche von (16)
- 18: Brennpunkt von (16)
- 19: Lichtaustrittsfläche, ringförmig von (10)

- 21: Hohlkehle
- 22: optische Achse von (10)

- 30, 50: Lichtverteiler
- 31, 51: Lichteintrittsflächen
- 32, 52: Lichtaustrittsflächen
- 33, 53: Seitenflächen
- 34, 54: Seitenflächen
- 35, 55: Stirnseitenfläche, kurz von (30; 50)
- 36, 56: Stirnseitenfläche, lang von (30; 50)
- 37, 57: Flächenelemente, schrägliegend
- 38, 58: Flächenelemente, normal zu (9)
- 39, 59: Freiflächenelemente
- 40, 60: Flächenelemente, klein; Stufenflächenelemente
- 41, 61: Flächenelemente, groß; Stufenflächenelemente
- 42, 62: Flächenelemente, Freiflächenelemente

- 44, 64: Scheitelstrecken

- 49: Spalt

- 70: Flächenlichtleiter
- 71: Grundfläche
- 72: Unterseite, Planfläche
- 73: Vorderseite, Lichtaustrittsfläche
- 74: Rückseitenfläche
- 75: Kerben
- 76: Kerbflächen
- 77: Kerbflächen
- 78: Rückseite von (70)

- 81: optische Strukturen
- 82: Ellipsoidenausschnitte

- 101 - 108: Licht, Lichtbündel
- 111: Lücken
- 113: Parallelisierendes optisches Element, Kollimator

- 135: Lichtteiler
- 137: Lichtreflexionsflächen
- 138: Lichtdurchtrittsflächen

- 140: Lichtumlenkbereich
- 142, 143: Lichtumlenkflächen
- 145 - 147: Lichtumlenkflächen

- 171: Lichtpfad
- 172: Lichtpfad

- 176 - 178: Lichtreflexionsflächen

- 238: Flächenelemente
- 239: Freiflächenelemente
- 240: kleine Stufenflächenelemente
- 241: große Stufenflächenelemente

- 244: Scheitelstrecken an (240)
- 245: Scheitelstrecken an (241)

- 338: Flächenelemente
- 339: Freiflächenelemente
- 340: kleine Stufenflächenelemente
- 341: große Stufenflächenelemente

- 344: Scheitelstrecken

## Patentansprüche

1. Leuchteinheit (5) mit mindestens einer Lichtquelle (10), mit mindestens einem der Lichtquelle (10) optisch nachgeschalteten, Lichtreftexionsflächen (137) aufweisenden Lichtteiler (135) und mit mindestens einem den Lichtreflexionsflächen (137) optisch nachgeschalteten Lichtumlenkbereich (140), wobei die Richtung des umgelenkten und den Lichtumlenkbereich (140) verlassenden Lichts von der Lichtquelle (10) weg zeigt, wobei dem Lichtteiler (135) ein optisches Element (113) optisch vorgeschaltet ist, das in der Lichtquelle (10) erzeugtes Licht (101 - 108) zumindest annähernd parallelisiert und wobei der Lichtteiler (135) von der Lichtquelle (10) durchleuchtete Lichtdurchtrittsflächen (138) aufweist, die zumindest annähernd normal zur Richtung (9) des parallelen Lichts (101 - 108) liegen, **dadurch gekennzeichnet, dass** den Lichtumlenkflächen (142, 143, 145 -147) des Lichtumlenkbereichs (140) und den Lichtdurchtrittsflächen (138) ein Flächenlichtleiter (70) optisch nachgeschaltet ist.

2. Leuchteinheit nach Anspruch 1, **dadurch gekennzeichnet, dass** das optische Element (113) Teil der Lichtquelle (10) ist.

3. Leuchteinheit nach Anspruch 1, **dadurch gekennzeichnet, dass** der Lichtumlenkbereich (140) gestaffelt angeordnete Lichtumlenkflächen (142, 143, 145 - 147) aufweist.

4. Leuchteinheit nach Anspruch 1, **dadurch gekennzeichnet, dass** zumindest eine Lichtreflexionsfläche (137), mindestens eine Lichtdurchtrittsfläche (138) und zumindest eine Lichtumlenkfläche (142; 143; 145; 146; 147) Grenzflächen eines Lichtverteilers (30; 50) sind.

5. Leuchteinheit nach Anspruch 4, **dadurch gekennzeichnet, dass** zumindest ein Lichtverteiler (30; 50) eine plane Lichteintrittsseite (31; 51) aufweist.

6. Leuchteinheit nach Anspruch 4, **dadurch gekennzeichnet, dass** die Größe der Lichtumlenkflächen (142, 143, 145 - 147) mit zunehmendem Abstand vom Lichtteiler (135) zunimmt.

7. Leuchteinheit nach Anspruch 1, **dadurch gekennzeichnet, dass** die Richtung (9) des von der Lichtquelle emittierten Lichts zumindest annähernd gleich der Richtung des umgelenkten und den Lichtumlenkbereich (140) verlassenden Lichts (102, 103, 105 - 107) ist.

8. Leuchteinheit nach Anspruch 1, **dadurch gekennzeichnet, dass** die Richtung des im Lichtumlenkbereich (140) umgelenkten Lichts (102, 103, 105 - 107) gleich der Richtung des die Lichtdurchtrittsflächen (138) durchtretenden Lichts (101, 104, 108) ist.

9. Leuchteinheit nach Anspruch 3, **dadurch gekennzeichnet, dass** in einer Projektion entgegen der Richtung der an den Lichtumlenkflächen (142, 143, 145 -147) umgelenkten Lichtbündel (102, 103, 105 - 107) der Abstand der Lichtumlenkflächen (142, 143, 145 - 147) zueinander gleich ist.

10. Leuchteinheit nach Anspruch 8 und 9, **dadurch gekennzeichnet, dass** in einer Projektion entgegen der Richtung der an den Lichtumlenkflächen (142, 143, 145 -147) umgelenkten Lichtbündel (102, 103, 105 - 107) der Abstand der Lichtdurchtrittsflächen (138) und der Lichtumlenkflächen (142, 143, 145 - 147) zueinander gleich ist.

11. Leuchteinheit nach Anspruch 1, **dadurch gekennzeichnet, dass** die Lichtquelle (10) Bereiche unterschiedlicher Lichtstärke hat und dass Bereiche hoher Lichtstärke kleine Lichtumlenkflächen (142, 143, 145 - 147) und Lichtdurchtrittsflächen (138) ausleuchten.

12. Leuchteinheit nach Anspruch 1, **dadurch gekennzeichnet, dass** die Lichtquelle eine Leuchtdiode (10) ist.

13. Leuchteinheit nach Anspruch 12, **dadurch gekennzeichnet, dass** die Leuchtdiode (10) einen paraboloidförmigen Lichtumlenkkörper (13) umfasst.

14. Leuchteinheit nach den Ansprüchen 4 und 12, **dadurch gekennzeichnet, dass** die Leuchtdiode (10) in mindestens einen Lichtverteiler (30; 50) integriert ist.

15. Leuchteinheit nach Anspruch 1, **dadurch gekennzeichnet, dass** die Lichtaustrittsfläche (73) des Flächenlichtleiters (70) mindestens zwanzigmal so groß ist wie die Lichtaustrittsflächen (16, 19) der Lichtquelle (10).

16. Leuchteinheit nach Anspruch 15, **dadurch gekennzeichnet, dass** der Flächenlichtleiter (70) transparent ist und optische Strukturen (81) umfasst.

17. Leuchteinheit nach Anspruch 15, **dadurch gekennzeichnet, dass** sie eine weitere Lichtquelle umfasst, die Licht in einer Richtung zumindest annähernd normal zur Lichtaustrittsfläche (73) des Flächenlichtleiters (70) emittiert.

## Claims

1. Lamp unit (5) having at least one light source (10), at least one light divider (135) optically behind the light source (10) and having light reflection surfaces (137), and at least one light deflection area (140) optically behind the light reflection surfaces (137), where the direction of the deflected light leaving the light deflection area (140) points away from the light source (10), where an optical element (113) is provided optically in front of the light divider (135) and at least approximately parallelizes the light (101 - 108) generated in the light source (10), and where the light divider (135) has light transmission surfaces (138) illuminated by the light source (10) and at least approximately normal to the direction (9) of the parallel light (101 - 108), **characterized in that** a surface light guide (70) is provided optically behind the light deflection surfaces (142, 143, 145 - 147) of the light deflection area (140) and of the light transmission surfaces (138).

2. Lamp unit according to Claim 1, **characterized in that** the optical element (113) is part of the light source (10).

3. Lamp unit according to Claim 1, **characterized in that** the light deflection area (140) has light deflection surfaces (142, 143, 145 - 147) arranged staggered.

4. Lamp unit according to Claim 1, **characterized in that** at least one light reflection surface (137), at least one light transmission surface (138) and at least one light deflection surface (142; 143; 145; 146; 147) are boundary surfaces of a light distributor (30; 50).

5. Lamp unit according to Claim 4, **characterized in that** at least one light distributor (30; 50) has a plane light input side (31; 51).

6. Lamp unit according to Claim 4, **characterized in that** the size of the light deflection surfaces (142, 143, 145 - 147) increases as the distance from the light divider (135) increases.

7. Lamp unit according to Claim 1, **characterized in that** the direction (9) of the light emitted by the light source is at least approximately equal to the direction of the deflected light (102, 103, 105 - 107) leaving the light deflection area (140).

8. Lamp unit according to Claim 1, **characterized in that** the direction of the light (102, 103, 105 - 107) deflected in the light deflection area (140) is equal to the direction of the light (101, 104, 108) passing through the light transmission surfaces (138).

9. Lamp unit according to Claim 3, **characterized in that** in a projection against the direction of the light beams (102, 103, 105 - 107) deflected at the light deflection surfaces (142, 143, 145 - 147), the distance of the light deflection surfaces (142, 143, 145 - 147) from one another is equal.

10. Lamp unit according to Claims 8 and 9, **characterized in that** in a projection against the direction of the light beams (102, 103, 105 - 107) deflected at the light deflection surfaces (142, 143, 145 - 147), the distance of the light transmission surfaces (138) and the light deflection surfaces (142, 143, 145 - 147) from one another is equal.

11. Lamp unit according to Claim 1, **characterized in that** the light source (10) has areas of differing light intensity and **in that** areas of high light intensity illuminate small light deflection surfaces (142, 143, 145 - 147) and light transmission surfaces (138).

12. Lamp unit according to Claim 1, **characterized in that** in the light source is a light-emitting diode (10).

13. Lamp unit according to Claim 12, **characterized in that** the light-emitting diode (10) comprises a paraboloid-shaped light deflection element (13).

14. Lamp unit according to Claims 4 and 12, **characterized in that** the light-emitting diode (10) is integrated into at least one light distributor (30; 50).

15. Lamp unit according to Claim 1, **characterized in that** the light output surface (73) of the surface light guide (70) is at least twenty times the size of the light output surfaces (16, 19) of the light source (10).

16. Lamp unit according to Claim 15, **characterized in that** the surface light guide (70) is transparent and comprises optical structures (81).

17. Lamp unit according to Claim 15, **characterized in that** it comprises a further light source which emits light in a direction at least approximately normal to the light output surface (73) of the surface light guide (70).

## Revendications

1. Bloc optique (5) avec au moins une source lumineuse (10), avec au moins un séparateur de lumière (135) situé optiquement en aval de la source lumineuse (10) et présentant des surfaces réfléchissant la lumière (137), et avec au moins une zone déviant la lumière (140) située optiquement en aval des surfaces réfléchissant la lumière (137), sachant que la lumière déviée et quittant la zone déviant la lumière (140) se propage dans le sens opposé à la source lumineuse (10), qu'en amont optiquement du séparateur de lumière (135) est placé un élément optique (113) qui parallélise au moins approximativement la lumière (101 à 108) générée dans la source lumineuse (10), et que le séparateur de lumière (135) présente des surfaces laissant passer la lumière (138) émise par la source lumineuse (10), qui sont au moins approximativement perpendiculaires à la direction (9) de la lumière parallèle (101 à 108), **caractérisé en ce qu'**un conducteur optique surfacique (70) est situé optiquement en aval des surfaces déviant la lumière (142, 143, 145 à 147) de la zone déviant la lumière (140) et des surfaces laissant passer la lumière (138).

2. Bloc optique selon la revendication 1, **caractérisé en ce que** l'élément optique (113) est une partie de la source lumineuse (10).

3. Bloc optique selon la revendication 1, **caractérisé en ce que** la zone déviant la lumière (140) présente des surfaces déviant la lumière (142, 143, 145 à 147) disposées en gradins.

4. Bloc optique selon la revendication 1, **caractérisé en ce qu'**au moins une surface réfléchissant la lumière (137), au moins une surface laissant passer la lumière (138) et au moins une surface déviant la lumière (142 ; 143 ; 145 ; 146 ; 147) sont des surfaces limites d'un diffuseur de lumière (30 ; 50).

5. Bloc optique selon la revendication 4, **caractérisé en ce qu'**au moins un diffuseur de lumière (30 ; 50) présente une face d'entrée de la lumière plane (31 ; 51).

6. Bloc optique selon la revendication 4, **caractérisé en ce que** la taille des surfaces déviant la lumière (142, 143, 145 à 147) augmente au fur et à mesure qu'elles s'éloignent du séparateur de lumière (135).

7. Bloc optique selon la revendication 1, **caractérisé en ce que** la direction (9) de la lumière émise par la source lumineuse est au moins approximativement identique à la direction de la lumière (102, 103, 105 à 107) déviée et quittant la zone déviant la lumière (140).

8. Bloc optique selon la revendication 1, **caractérisé en ce que** la direction de la lumière (102, 103, 105 à 107) déviée dans la zone déviant la lumière (140) est identique à la direction de la lumière (101, 104, 108) traversant les surfaces laissant passer la lumière (138).

9. Bloc optique selon la revendication 3, **caractérisé en ce que** dans une projection en sens inverse de la direction des faisceaux lumineux (102, 103, 105 à 107) déviés sur les surfaces déviant la lumière (142, 143, 145 à 147), la distance entre les surfaces déviant la lumière (142, 143, 145 à 147) est constante.

10. Bloc optique selon les revendications 8 et 9, **caractérisé en ce que** dans une projection en sens inverse de la direction des faisceaux lumineux (102, 103, 105 à 107) déviés sur les surfaces déviant la lumière (142, 143, 145 à 147), la distance entre les surfaces laissant passer la lumière (138) et entre les surfaces déviant la lumière (142, 143, 145 à 147) est constante.

11. Bloc optique selon la revendication 1, **caractérisé en ce que** la source lumineuse (10) a des zones de différentes luminosités et que les zones de forte luminosité éclairent des petites surfaces déviant la lumière (142, 143, 145 à 147) et des surfaces laissant passer la lumière (138).

12. Bloc optique selon la revendication 1, **caractérisé en ce que** la source lumineuse est une diode électroluminescente (10).

13. Bloc optique selon la revendication 12, **caractérisé en ce que** la diode électroluminescente (10) comprend un corps parabolique (13) déviant la lumière.

14. Bloc optique selon les revendications 4 et 12, **caractérisé en ce que** la diode électroluminescente (10) est intégrée dans au moins un diffuseur de lumière (30 ; 50).

15. Bloc optique selon la revendication 1, **caractérisé en ce que** les surfaces de sortie de la lumière (73) du conducteur optique surfacique (70) sont au moins vingt fois plus grandes que les surfaces de sortie de la lumière (16, 19) de la source lumineuse (10).

16. Bloc optique selon la revendication 15, **caractérisé en ce que** le conducteur optique surfacique (70) est transparent et comprend des structures optiques (81).

17. Bloc optique selon la revendication 15, **caractérisé en ce qu'**il comprend une autre source lumineuse qui émet de la lumière dans une direction au moins approximativement perpendiculaire aux surfaces de sortie de la lumière (73) du conducteur optique surfacique (70).
